(19) Europäisches Patentamt
European Patent Office
Office européen des brevets

(11) **EP 1 978 542 B1**

(12) **EUROPÄISCHE PATENTSCHRIFT**

(45) Veröffentlichungstag und Bekanntmachung des Hinweises auf die Patenterteilung:
**29.12.2010 Patentblatt 2010/52**

(51) Int Cl.:
***H01J 37/32*** *(2006.01)*     *H01J 37/34* *(2006.01)*

(21) Anmeldenummer: **07004758.4**

(22) Anmeldetag: **08.03.2007**

(54) **Verfahren und Vorrichtung zum Unterdrücken von Bogenentladungen beim Betreiben eines Plasmaprozesses**

Method and device for suppressing arc discharges during a plasma process

Procédé et dispositif pour supprimer les décharges d'arc dans un procédé plasma

(84) Benannte Vertragsstaaten:
**AT BE BG CH CY CZ DE DK EE ES FI FR GB GR HU IE IS IT LI LT LU LV MC MT NL PL PT RO SE SI SK TR**

(43) Veröffentlichungstag der Anmeldung:
**08.10.2008 Patentblatt 2008/41**

(73) Patentinhaber: **HÜTTINGER Elektronik GmbH + Co. KG**
**79111 Freiburg (DE)**

(72) Erfinder: **Wiedemuth, Peter**
**79336 Herbolzheim (DE)**

(74) Vertreter: **Kohler Schmid Möbus**
**Patentanwälte**
**Ruppmannstraße 27**
**70565 Stuttgart (DE)**

(56) Entgegenhaltungen:
**EP-A1- 1 705 687**     **DE-A1- 4 127 504**
**US-A- 5 993 615**     **US-A1- 2004 031 699**
**US-B1- 6 332 961**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft ein Verfahren zum Unterdrücken von Bogenentladungen beim Betreiben eines Plasmaprozesses, bei dem als Gegenmaßnahme zur Unterdrückung von Bogenentladungen eine Leistungsversorgung des Plasmaprozesses in Abhängigkeit von wenigstens einer Kenngröße unterbrochen oder umgepolt wird.

Weiterhin betrifft die vorliegende Erfindung eine Bogenentladungserkennungseinrichtung für einen Plasmaprozess, aufweisend: eine Überwachungseinheit, die zum Überwachen wenigstens einer Kenngröße zum Erkennen einer Bogenentladung in dem Plasmaprozess anhand der Kenngröße und zum Ausgeben eines entsprechenden Überwachungssignals ausgebildet ist; eine Steuereinheit, die zum Empfangen des Überwachungssignals von der Überwachungseinheit und zum Ausgeben eines Steuersignals zum Bewirken einer Gegenmaßnahme zum Unterdrücken der Bogenentladung ausgebildet ist; und eine Timer-Einheit, die zum Liefern eines Zeitreferenzsignals an die Steuereinheit ausgebildet ist.

Außerdem betrifft die vorliegende Erfindung eine Plasmaleistungsversorgungseinrichtung mit einer Leistungsquelle für eine Leistungsversorgung des Plasmaprozesses.

Mit Plasma kann beschichtet, geätzt oder geascht werden. Ein sehr häufiger Plasmaprozess ist das so genannte Sputtern, bei dem mittels beschleunigter Ionen aus dem Plasma von einem Target Atome abgetragen werden, die sich auf einem Substrat ablagern. Beim Sputtern werden häufig reaktive Gase zugesetzt, um Verbundstoffe wie z.B. $Al_2O_3$ auf dem Substrat abzulagern Diese Art des Sputterns nennt man reaktives Sputtern. Beim reaktiven Sputtern kommt es zur Bildung von isolierenden Schichten auch auf dem Target. Die Ionen, die auf das Target beschleunigt werden, laden solche isolierenden Schichten auf. Übersteigt die Feldstärke einer derart aufgeladenen isolierenden Schicht die Durchbruchfeldstärke, kommt es zu Bogenentladungen, so genannten Arcs. Diese können kurz und selbstverlöschend sein (so genannte Short- oder Mikro-Arcs) oder lang andauernd und sehr energiereich (so genannte Hard-Arcs). Short Arcs verursachen zumeist nur einen sehr geringen Schaden und können für viele Prozesse (z.B. Glasbeschichtung) zugelassen werden. Hard Arcs führen in der Regel zur Zerstörung des Targets und zu nicht tolerierbaren Fehlstellen auf dem Substrat. Daher werden Hard-Arcs in der Regel immer durch entsprechende Gegenmaßnahmen gelöscht.

Um die vorstehend genannten Maßnahmen überhaupt einleiten zu können, sind Vorrichtungen zur Bogenentladungserkennung (Arc-Erkennung) sowie zur Unterdrückung oder Löschung der Bogenentladungen (Arcs) vielfach Bestandteil der Plasma-Leistungsversorgung.

Wichtig ist dabei in erster Linie die Zuverlässigkeit der Erkennung von Bogenentladungen oder Arcs.

Eine Bogenentladung kann durch einen Spannungseinbruch bzw. einen Spannungsabfall oder einen Stromanstieg am Ausgang der Plasma-Leistungsversorgung erkannt werden. Mit anderen Worten: Durch Überwachung wenigstens einer entsprechenden Kenngröße, hier einer elektrischen Kenngröße des Plasmaprozesses lässt sich eine Bogenentladungserkennung durchführen.

Wie bereits ausgeführt wurde, können in dem Plasmaprozess nicht nur andauernde Bogenentladungen, so genannte "Hard-Arcs", auftreten, die unter Umständen zu einer völligen Zerstörung des Substrats oder des Targets führen, sondern auch so genannte "Short- oder Mikro-Arcs" (nachfolgend auch zusammenfassend als Short-Arcs bezeichnet), die regelmäßig schwächer ausgeprägt sind und von selbst verlöschen. Allerdings ist auch bekannt, dass derartige Short-Arcs zu Hard-Arcs anwachsen können, wenn keine entsprechenden Gegenmaßnahmen ergriffen werden.

Wie beispielsweise durch die EP 0 692 138 B1 dokumentiert, ist zu diesem Zweck vorgeschlagen worden, periodisch gepulste Gegenmaßnahmen zum Unterdrücken von Bogenentladungen in Plasmaprozessen auszulösen. Derartige Gegenmaßnahmen erfolgen regelmäßig in Form von so genannten Pulsen, bei denen eine Energiezufuhr für den Plasmaprozess pulsartig unterbrochen und gegebenenfalls eine Ausgangsspannung einer Gleichspannungsquelle der Plasma-Leistungsversorgung umgepolt wird. Ein derartiger Puls kann periodisch gesteuert sein oder aber auch als Reaktion auf das Erkennen eines Arcs erfolgen; er wird nachfolgend auch als Bogenentladungs-Löschungspuls bezeichnet.

Das periodische Pulsen besitzt den Nachteil, dass eine Bearbeitungsrate des Plasmaprozesses, beispielsweise eine Abscheidungsrate oder dergleichen, durch das Pulsen über Gebühr verringert wird, wenn eine Unterbrechung der Energiezufuhr häufiger stattfindet, als dies aufgrund tatsächlich stattfindender Bogenentladungen in dem Plasmaprozess erforderlich wäre.

Aus der EP 1705687 A1 ist ein Verfahren bekannt, wonach beim Erkennen eines Arcs die Leistungszufuhr zu einem Plasmaprozess unterbrochen wird. Zur Arc-Erkennung ist vorgeschen, dass die gemessene Dauer einer Halbwelle als Referenzgröße verwendet werden kann, die mit einem Schwellenwert verglichen wird. Je nach Vergleichsergebnis wird eine Gegenmaßnahme zur Arcing eingeleitet.

Der Erfindung liegt die Aufgabe zugrunde, die negativen Auswirkungen von Bogenentladungen auf den Plasmaprozess und die zur Durchführung desselben verwendeten Anlagen auf ein Mindestmaß zu reduzieren und dabei die Bearbeitungsrate möglichst hoch zu halten.

Nach einem ersten Aspekt der vorliegenden Erfindung wird die Aufgabe bei einem Verfahren der eingangs genannten Art dadurch gelöst, dass ein zeitlicher Verlauf der Gegenmaßnahme in Abhängigkeit von wenigstens einem der nachfolgenden Parameter selektiv bestimmt wird: zeitlicher Abstand zu wenigstens einer vorhergehenden Gegenmaßnahme; Verlauf der wenigstens einen Kenngröße seit einem betreffenden Einsatzzeitpunkt oder seit einer variablen Zeit vor dem betreffenden Einsatzzeitpunkt; Unterscheidung, ob eine vorhergehende Gegenmaßnahme aufgrund des Verlaufs der wenigstens einen Kenngröße oder aufgrund des zeitlichen Abstands zu wenigstens einer vorhergehenden Gegenmaßnahme ausgelöst wurde.

Nach einem zweiten Aspekt der vorliegenden Erfindung wird die Aufgabe bei einer Bogenentladungserkennungseinrichtung der eingangs genannten Art dadurch gelöst, dass die Steuereinheit dafür eingerichtet ist, ein Verfahren gemäß dem ersten Aspekt der vorliegenden Erfindung durchzuführen.

Weiterhin wird die Aufgabe bei einer Plasmaleistungsversorgungseinrichtung der eingangs genannten Art dadurch gelöst, dass diese in Wirkverbindung mit der Leistungsquelle eine Bogenentladungserkennungseinrichtung gemäß dem zweiten Aspekt der vorliegenden Erfindung aufweist.

Bei einer Ausgestaltung der vorliegenden Erfindung wird somit aus dem zeitlichen Verlauf einer Kenngröße, wie zum Beispiel Spannung oder Strom sowie den Zeitpunkten vorangegangener Unterbrechungen der Leistungszufuhr der Zeitpunkt einer nächsten zu erwartenden Bogenentladung vorbestimmt und bei Erreichen dieses Zeitpunktes eine entsprechende pulsartige Unterbrechung der Energiezufuhr, gegebenenfalls mit Umpolung der Ausgangsspannung einer Spannungsquelle zur Plasma-Leistungsversorgung, ausgelöst. Nachfolgend wird dies sprachlich dadurch zu Ausdruck gebracht, dass allgemein von einem "Pulsen" der Energiezufuhr gesprochen wird.

Gepulst wird dabei ein- oder mehrmalig, jedoch nur nach erkannten Bogenentladungen. Mit anderen Worten: Es muss erfindungsgemäß zunächst eine Bogenentladung anhand der überwachten Kenngröße erkannt werden; anschließend wird wenigstens eine entsprechende Gegenmaßnahme ausgelöst, an die sich gegebenenfalls in selektiv angepasster zeitlicher Abfolge noch weitere Gegenmaßnahmen anschließen können. Bei häufigem Auftreten von Bogenentladungen in dem Plasmaprozess ähnelt das erfindungsgemäße Verfahren dem vorbekannten periodischen Pulsen. Allerdings erfolgen keine Gegenmaßnahmen (kein Pulsen), wenn keine Bogenentladungen auftreten.

Die Bogenentladungen werden erfindungsgemäß grundsätzlich unverzüglich, d.h. mit geringstmöglicher Verzögerungszeit, die typischerweise in der Größenordnung von einigen zehn bis hundert Nanosekunden liegt, aktiv durch Unterbrechen der Energiezufuhr und eventuell durch Umpolen der Ausgangsspannung gelöscht. Die Dauer eines entsprechendes Bogenentladungs-Löschungspulses soll dabei typischerweise 1 bis 5 μs nicht übersteigen, sodass die Bearbeitungsrate eines Plasmaprozesses nicht oder nur unwesentlich beeinträchtigt wird.

Aus dem Verlauf der Kenngröße, wie Strom oder Spannung, während des Bogenentladungs-Löschungsvorganges und/oder der Zeit, die seit dem Auftreten wenigstens einer vorhergehenden Bogenentladung vergangen ist, wird gemäß einer Ausgestaltung der vorliegenden Erfindung ermittelt, ob es sich um einen Short-Arc oder einen Hard-Arc handelt. Bei Vorliegen eines Hard-Arcs kann die Dauer der Unterbrechung der Energiezufuhr gemäß einer Ausgestaltung der vorliegenden Erfindung entsprechend verlängert werden, um auch eine solche Bogenentladung sicher zu löschen.

Weitere vorteilhafte Ausgestaltungen der vorliegenden Erfindung, insbesondere des erfindungsgemäßen Verfahrens, sind Gegenstand von Unteransprüchen, deren Wortlaut hiermit durch Bezugnahme in die vorliegende Beschreibung aufgenommen wird, um unnötige Textwiederholungen zu vermeiden.

Weitere Merkmale und Vorteile der Erfindung ergeben sich aus der nachfolgenden Beschreibung von Ausführungsbeispielen der Erfindung anhand der Figuren der Zeichnung, welche erfindungswesentliche Einzelheiten zeigen, sowie aus den Ansprüchen. Die einzelnen Merkmale können dabei jeweils einzeln für sich oder zu mehreren in beliebiger Kombination bei einer Variante der Erfindung verwirklicht sein.

Bevorzugte Ausführungsbeispiele der Erfindung sind in der Zeichnung schematisch dargestellt und werden nachfolgend mit Bezug zu den Figuren der Zeichnung näher erläutert. Es zeigt:

Fig. 1     ein schematisches Blockschaltbild einer erfindungsgemäßen Leistungsversorgungseinrichtung für einen Plasmaprozess mit einer erfindungsgemäßen Bogenentladungserkennungseinrichtung;

Fig. 2     ein Zeitablaufdiagramm eines Bogenentladungs-Löschungs- zyklus gemäß einer Ausgestaltung des erfindungsgemäßen Verfahrens;

Fig. 3     ein Flussdiagramm zur Darstellung einer weiteren Ausge- staltung des erfindungsgemäßen Verfahrens;

Fig. 4     ein Zeitablaufdiagramm zur Darstellung einer weiteren Ausge- staltung des erfindungsgemäßen Verfahrens; und

Fig. 5     ein Flussdiagramm zur Darstellung einer weiteren Ausge- staltung des erfindungsgemäßen Verfahrens.

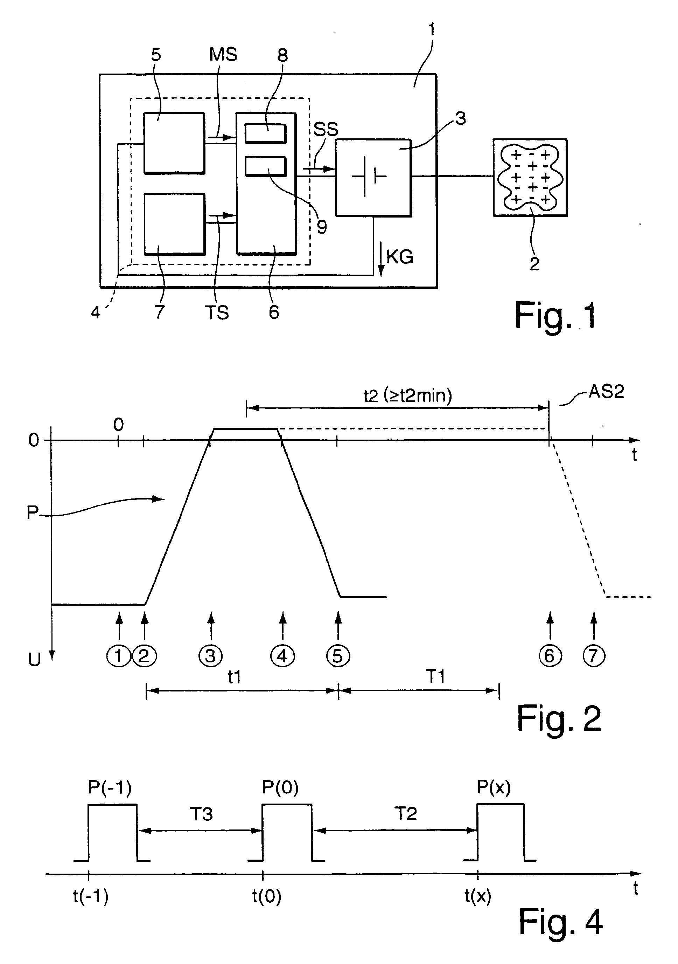

Fig. 1 zeigt ein schematisches Blockschaltbild einer erfindungsgemäßen Leistungsversorgungseinrichtung 1 für einen Plasmaprozess 2 mit einer erfindungsgemäßen Bogenentladungserkennungseinrichtung. Die erfindungsgemäße Leistungsversorgungseinrichtung 1 umfasst im vorliegenden Fall eine Gleichspannungsquelle 3 zur Gleichspannungsversorgung des Plasmaprozesses 2 sowie eine Bogenentladungserkennungseinrichtung 4, die in signaltechnischer Wirkverbindung mit der Gleichspannungsquelle 3 angeordnet ist. Die Bogenentladungserkennungseinrichtung 4 umfasst ihrerseits eine Überwachungseinheit 5, eine Steuereinheit 6 sowie eine Timer-Einheit 7. Die Steuereinheit 6 weist zusätzlich noch eine Speichereinheit 8 sowie eine Recheneinheit 9 auf. Die Überwachungseinheit 5 ist signaltechnisch mit der Gleichspannungsquelle 3 verbunden. Die Überwachungseinheit 5 und die Timer-Einheit 7 sind jeweils signaltechnisch mit der Steuereinheit 6 verbunden. Die Steuereinheit 6 ist ihrerseits signaltechnisch mit der Gleichspannungsquelle 3 verbunden.

Zum Erkennen von Bogenentladungen (so genannten Arcs) im den Plasmaprozess 2 ist die Überwachungseinheit 5 zur Überwachung wenigstens einer Kenngröße KG der Plasma-Gleichspannungsversorgung, d.h. der Gleichspannungsquelle 3, ausgebildet. Wie einem Fachmann geläufig ist, kann es sich bei der genannten Kenngröße insbesondere um eine Spannung oder einen Strom der Gleichspannungsquelle 3 handeln. Auch die Messung einer Leistungs-Kenngröße kann hier gemeint sein, wie sie vor allem bei Hochfrequenz (HF)-Plasmaleistungsversorgungen eingesetzt wird, beispielsweise die Messung von Vorwärtsleistung $P_I$, und Rückwärtsleistung $P_R$. Es ist auch möglich eine externe Kenngröße zur Bogenentladungserkennung heranzuziehen.

Bei Auftreten einer Bogenentladung in dem Plasmaprozess 2 kommt es bekannter Weise zu einem entsprechenden Spannungsabfall bzw. Spannungseinbruch in Verbindung mit einem entsprechend erhöhten Stromfluss. Diese Auswirkungen einer Bogenentladung lassen sich durch Überwachen der Kenngröße KG bzw. eines entsprechenden Kenngrößensignals durch die Überwachungseinheit 5 nachweisen. Die Überwachungseinheit 5 ist weiterhin zum Ausgeben eines entsprechenden Überwachungssignals MS an die Steuereinheit 6 ausgebildet. Durch Ausgeben des Überwachungssignals MS wird der Steuereinheit 6 durch die Überwachungseinheit 5 mitgeteilt, dass letztere durch Überwachen der Kenngröße KG das Vorhandensein einer Bogenentladung in dem Plasmaprozess 2 erkannt hat.

Die Steuereinheit 6 ist ihrerseits zum Empfangen des Überwachungssignals MS von der Überwachungseinheit 5 ausgebildet. Wie im Zuge der nachfolgenden Beschreibung noch detailliert beschrieben wird, ist die Steuereinheit 6 dazu ausgebildet, nach Maßgabe des Überwachungssignals MS sowie weiterer empfangener Signale in geeigneter Weise Steuersignale SS zu erzeugen und an die Gleichspannungsquelle 3 auszugeben, um diese zum Unterdrücken oder Löschen von Bogenentladungen in dem Plasmaprozess 2 zu steuern. Insbesondere kann durch die Steuersignale SS - wie dem Fachmann an sich bekannt ist - ein Unterbrechen oder Umpolen der Plasma-Gleichspannungsversorgung, d.h.

der Gleichspannungsquelle 3, bewirkbar sein.

Im Zuge der vorliegenden Beschreibung werden die vorstehend beispielhaft erwähnten Maßnahmen zum Unterdrücken einer Bogenentladung verallgemeinernd auch als "Gegenmaßnahmen" bezeichnet.

Die weiterhin in der Bogenentladungserkennungseinrichtung 4 enthaltene Timer-Einheit 7 ist zum Liefern eines Zeitreferenzsignals TS an die Steuereinheit 6 ausgebildet. Somit ist es durch Zusammenwirken der Überwachungseinheit 5 und der Timer-Einheit 7 möglich, die durch die Überwachungseinheit 5 erzeugten und an die Steuereinheit 6 ausgegebenen Überwachungssignale, wie das erwähnte Überwachungssignal MS, in Bezug auf ihren Erzeugungs- bzw. Ausgabezeitpunkt zeitlich zuzuordnen. Mit anderen Worten: Durch das Zusammenwirken der Überwachungseinheit 5 und der Timer-Einheit 7, d.h. der Überwachungssignale MS und des Zeitreferenzsignals TS ist die Steuereinheit 6 in der Lage zu erkennen, wann ein bestimmtes Überwachungssignal MS erzeugt bzw. ausgegeben wurde. Des Weiteren ist die Steuereinheit 6 aufgrund des Zeitreferenzsignals TS auch in der Lage, diejenigen Zeitpunkte zu erkennen bzw. zu bestimmen, zu denen sie selbst die genannten Steuersignale SS erzeugt bzw. ausgibt. Die entsprechenden Informationen werden in der Speichereinheit 8 in der Steuereinheit 6 abgelegt und können von der Recheneinheit 9 verwendet werden, worauf später noch genauer eingegangen wird.

Aufgrund der vorstehend beschriebenen erfindungsgemäßen Ausgestaltung ist die Leistungsversorgungseinrichtung 1 bzw. die Bogenentladungserkennungseinrichtung 4 in der Lage, ein erfindungsgemäßes Verfahren zum Betreiben eines Plasmaprozesses durchzuführen, wie nachfolgend unter Bezugnahme auf die Figuren 2 bis 5 eingehend erläutert wird.

Fig. 2 zeigt ein Zeitablaufdiagramm eines exemplarischen, schematisierten Bogenentladungs-Löschungszyklus gemäß einer Ausgestaltung des erfindungsgemäßen Verfahrens. Insbesondere zeigt Fig. 2 den zeitlichen Verlauf eines Spannungspulses P zum Unterbrechen der Energiezufuhr und gegebenenfalls zur Umpolung einer Ausgangsspannung der Gleichspannungsquelle 3 (Fig. 1), um auf diese Weise eine erkannte Bogenentladung in dem Plasmaprozess 2 (Fig. 1) zu löschen. Zum Zeitpunkt ①, beispielsweise zur Zeit t = 0, wird eine Bogenentladung in dem Plasmaprozess erkannt, wie oben anhand der Fig. 1 bereits eingehend beschrieben. Daraufhin wird bei ②, dem Einsatzzeitpunkt, beispielsweise zur Zeit t = 0,05 μs, d.h. nach einigen Nanosekunden der Löschungspuls eingeleitet, indem die Steuereinheit 6 (Fig. 1) entsprechende Steuersignale SS an die Gleichspannungsquelle 3 sendet. Dies geschieht nach Maßgabe eines zum Zeitpunkt ① oder kurz danach von der Überwachungseinheit 5 empfangenen Überwachungssignals MS, welches das Vorhandensein einer Bogenentladung in dem Plasmaprozess anzeigt. Zum Zeitpunkt ③, beispielsweise bei t = 0,7 μs, ist die Leistungszufuhr unterbrochen. Gemäß dem Ausführungsbeispiel der Fig. 2 erfolgt erfindungsgemäß sogar eine Umpolung (U > 0) der Ausgangsspannung der Gleichspannungsquelle 3 (Fig. 1).

Während der gesamten Zeit seit dem Erkennen der Bogenentladung, d.h. seit dem Zeitpunkt ①, d.h. vorzugsweise seit einer variablen Zeit vor dem betreffenden Einsatzzeitpunkt, zumindest aber mit diesem beginnend, werden die Strom- und/oder Spannungsverläufe des Plasmaprozesses 2 bzw. der Gleichspannungsquelle 3, d.h. wird die Kenngröße KG mit sehr hoher Wiederholrate durch die Überwachungseinheit 5 abgetastet und mit vorgegebenen Kriterien verglichen. Die Kriterien können ein Unterschreiten bzw. ein Überschreiten fester Schwellwerte sein. Die Schwellwerte können aber auch variabel sein, z.B. können sie sich über ein vorgegebenes Zeitintervall an einem Mittelwert oder Spitzenwert der überwachten Kenngröße orientieren. Die Kriterien können auch ein dynamisches Verhalten der Kenngröße beinhalten, also z.B. ein Maß der Änderungsgeschwindigkeit der Spannung dV/dt oder des Stroms dI/dt oder der Leistung dP/dt. Ein Kriterium kann auch das Frequenzspektrum einer Kenngröße sein. Es ist immer auch eine Kombination mehrerer Kriterien möglich.

Wird anhand der vorstehend exemplarisch aufgeführten Kriterien durch die Überwachungseinheit 5 ein so genannter "Hard-Arc", d.h. eine nicht selbst verlöschende Bogenentladung erkannt, so wird der Puls P in seinem zum Zeitpunkt ③ erreichten Zustand ab Erkennen des Hard-Arc während einer verlängerten Löschzeit t2 fortgesetzt, die erfindungsgemäß vorzugsweise eine vorgegebene Mindestdauer oder einen Minimalwert t2min von beispielsweise 20 μs aufweist. Gemäß dem Beispiel der Fig. 2 wird zu einer bestimmten Zeit zwischen den Zeitpunkten ③ und ④ ein solcher Hard-Arc erkannt, sodass dann die verlängerte Löschzeit t2 ≥ t2min aktiv wird, wie zeichnerisch dargestellt. Diese erstreckt sich bis zu einem Zeitpunkt ⑥, zu dem die Leistungszufuhr wieder aktiviert wird, woraufhin zu einem Zeitpunkt ⑦ die Unterbrechung der Energiezufuhr des Plasmaprozesses und damit der Puls P endet. Die vorstehend beschriebenen Zusammenhänge sind in Fig. 2 teilweise mittels der gestrichelten Linie dargestellt.

Wenn dagegen nach Maßgabe der mit hoher Wiederholrate abgetasteten Strom- oder Löschspannungsverläufe ein so genannter "Short-Arc" erkannt wird, der in der Regel weniger stark ausgeprägt ist als ein Hard-Arc und insbesondere von selbst wieder verlischt, wird zu einem Zeitpunkt ④, beispielsweise nach t = 2,7 μs, die Leistungszufuhr bzw. die Energiezufuhr des Plasmaprozesses wieder aktiviert, und der Puls P endet bei ⑤, beispielsweise nach t = 3,5 μs. Somit liegt die Gesamtdauer t1 des Pulses im Falle eines Short-Arcs nach dem dargestellten Ausführungsbeispiel bei etwa t1 = 3,5 μs. Generell sollte die Dauer eines solchen Pulses eine Zeit von 1 - 5 μs nicht übersteigen, da sonst die Bearbeitungsrate des Plasmaprozesses, beispielsweise eine Abscheiderate, zu stark beeinträchtigt würde.

Wie vorstehend ausgeführt, wird aus dem Verlauf einer Kenngröße während des Löschvorgangs erkannt, ob es sich um einen Short-Arc oder einen Hard-Arc handelt. Bei Vorliegen eines Hard-Arcs wird die Dauer der Unterbrechung oder Umpolung der Energiezufuhr entsprechend verlängert, um den Hard-Arc sicher zu löschen. Auf diese Weise wird erfindungsgemäß erreicht, dass alle Arten von Bogenentladungen bei kleinstmöglicher Arc-Energie und mit kürzestmöglicher Unterbrechung der Energiezufuhr gelöscht werden. Bei gehäuft auftretenden Bogenentladungen ergibt sich so eine Art regelmäßiger Pulsbetrieb. Durch das damit zusammenhängende kurze Pulsen (Pulsdauer ≤ 1 - 5 μs) bei jeder erkannten Bogenentladung, insbesondere auch bei einem Short-Arc, wird zudem erreicht, dass die Entstehung weiterer Bogenentladungen verzögert und damit einem gehäuften Auftreten von Bogenentladungen und entsprechender Beeinträchtigung der Bearbeitungsrate entgegengewirkt wird.

Im Rahmen der vorliegenden Erfindung ist im Zuge gewisser Ausgestaltungen zudem vorgesehen, dass auch eine Zeit, die seit dem Auftreten vorhergehender Bogenentladungen vergangen ist, mit in die "Behandlung" einer nachfolgenden Bogenentladung einfließt. Wird nämlich gemäß der Darstellung in Fig. 2 innerhalb einer Zeit T1 von beispielsweise 5 μs nach dem Ende eines Pulses P, d.h. nach dem Zeitpunkt ⑤, erneut eine Bogenentladung erkannt, was in Fig. 2 nicht explizit dargestellt ist, so wird die verlängerte Löschzeit t2 um einen bestimmten Wert oder ein bestimmtes Verlängerungsintervall [Δt2+] erhöht. Dabei kann das Verlängerungsintervall Δt2+ insbesondere auch 5 μs betragen. Der neue Wert für die verlängerte Löschzeit t2, d.h. t2' = t2 + [Δt2+] wird beim Erkennen des nächsten Hard-Arc wirksam und dann entsprechend zum Löschen des Hard-Arcs verwendet, wie oben detailliert beschrieben. Nach jedem gelöschten Hard-Arc, d.h. im Anschluss an den Zeitpunkt ⑦ in Fig. 2, wird die zweite Löschzeit t2 um einen vorgegebenen Wert oder ein Verkürzungsintervall [Δt2-] bis hinunter auf den bereits erwähnten voreingestellten Anfangs- oder Minimalwert t2min verringert. Dieser beträgt im Falle des Ausführungsbeispiels der Fig. 2 - wie erwähnt - t2min = 20 μs.

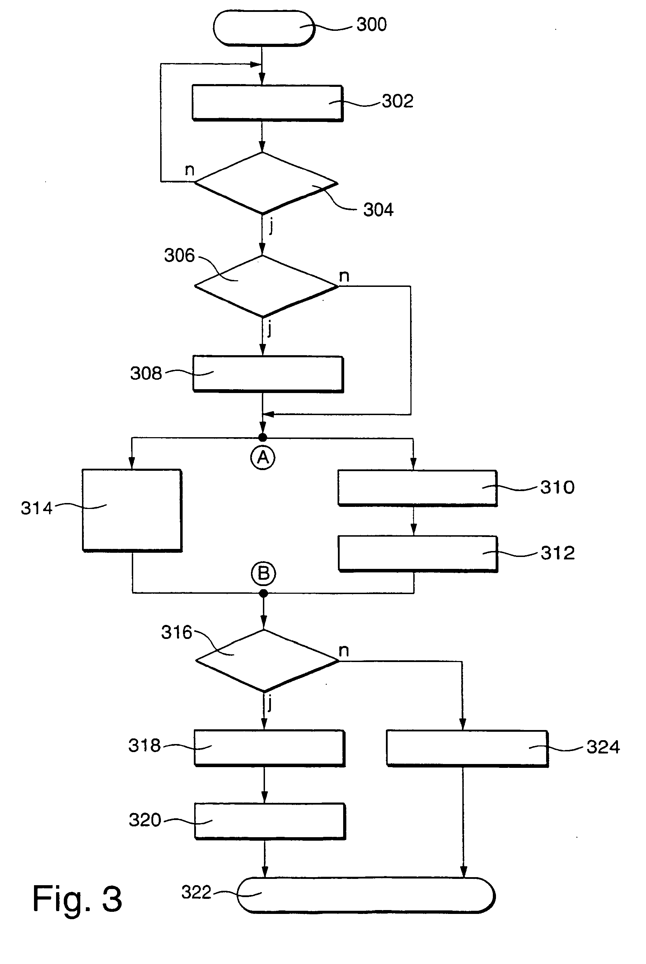

Mit anderen Worten: Wenn innerhalb der Zeit t1 nach Beendigung des Pulses P erneut eine Bogenentladung erkannt wird, wird dies im Rahmen der vorliegenden Erfindung als Anzeichen dafür bewertet, dass die bislang verwendeten Löschungsparameter das Entstehen von Bogenentladungen in dem Plasmaprozess noch nicht effizient genug unterdrücken. Entsprechend wird die Löschzeit t2 weiter erhöht, um dem Entstehen von Bogenentladungen besser entgegenzuwirken. Jedes Mal, wenn eine aufgetretene Bogenentladung erfolgreich gelöscht wurde, erfolgt erfindungsgemäß eine Verringerung der entsprechenden Löschzeit. Dabei geschieht die Verringerung der Löschzeit vorzugsweise langsamer als deren Erhöhung. Während das Verlängerungsintervall - wie erwähnt - vorzugsweise 5 μs beträgt, kann die Verringerung der Löschzeit t2 in Schritten von

nur 1 μs bis auf den voreingestellten Anfangswert erfolgen. Diese Zusammenhänge sind in Fig. 3 nochmals zusammenfassend dargestellt.

Fig. 3 zeigt ein Flussdiagramm zur Darstellung einer weiteren Ausgestaltung des erfindungsgemäßen Verfahrens. Das erfindungsgemäße Verfahren gemäß Fig. 3 beginnt in Schritt 300. In einem nachfolgenden Schritt 302 erfolgt das Überwachen der wenigstens einen elektrischen Kenngröße der Plasma-Gleichspannungsversorgung, wie weiter oben anhand der Figuren 1 und 2 bereits im Detail dargestellt. Anschließend wird in Schritt 304 überprüft, ob durch die Überwachung eine Bogenentladung erkannt wurde.

Ist dies der Fall (j), wird das Verfahren in Schritt 306 fortgesetzt. Anderenfalls (n) kehrt das Verfahren nach Schritt 302 zurück.

In Schritt 306 wird überprüft, ob die in Schritt 304 erkannte Bogenentladung innerhalb eines vorgegebenen Zeitintervalls seit Beendigung des vorangehenden Bogenentladung-Unterdrückungspulses liegt, wie oben anhand der Fig. 2 detailliert beschrieben. Ist dies nicht der Fall (n), wird das Verfahren unmittelbar bei (A) fortgesetzt. Andernfalls (j) wird in Schritt 308 die Löschzeit für erkannte Hard-Arcs um ein Verlängerungsintervall erhöht, wie bereits ausführlich dargelegt. Anschließend wird das Verfahren bei (A) fortgesetzt.

Ausgehend von (A) verzweigt sich das erfindungsgemäße Verfahren in zwei parallele Verfahrensstränge, die im Wesentlichen zeitgleich ausgeführt werden. Zum einen wird in Schritt 310 zunächst ein Bogenentladungs-Löschungspuls eingeleitet und dann die Leistungszufuhr des Plasmaprozesses unterbrochen (Schritt 312). Andererseits erfolgt in Schritt 314 im Wesentlichen parallel zu den Schritten 310 und 312 ein verstärktes Überwachen der Strom- und Spannungsverläufe mit sehr hoher Wiederholrate, wie ebenfalls bereits anhand der Fig. 2 eingehend beschrieben. Die abgetasteten Strom- und/oder Spannungsverläufe werden mit vorgegebenen Kriterien verglichen, um anschließend in Schritt 316 eine Unterscheidung zwischen Short-Arcs und Hard-Arcs vornehmen zu können. Im Anschluss an die Schritte 310 und 312 bzw. Schritt 314 wird das erfindungsgemäße Verfahren gemäß Fig. 3 in (B) fortgesetzt.

Anschließend wird in Schritt 316 überprüft, ob anhand der mit hoher Wiederholrate abgetasteten Strom- oder Spannungsverläufe ein Hard-Arc erkannt wurde. Im Falle eines erkannten Hard-Arcs (j) wird die zweite verlängerte Löschzeit aktiviert, wie ebenfalls bereits anhand von Fig. 2 beschrieben, Schritt 318. Anschließend wird in Schritt 320 nach Löschen des Hard-Arc die zweite Löschzeit um den Wert eines Verringerungsintervalls verringert, beispielsweise um 1 μs, sofern der voreingestellte Anfangswert noch nicht erreicht ist. Das Verfahren endet anschließend mit Schritt 322.

Falls in Schritt 316 kein Hard-Arc sondern nur ein Short-Arc erkannt wird (n), erfolgt die Darstellung in Schritt 324 nur während einer kürzeren ersten Löschzeit (in Fig. 2 mit t1 bezeichnet). Danach endet das Verfahren ebenfalls mit Schritt 322.

Nach Ablauf einer bestimmten Zeit nach der Beendigung eines Bogenentladungs-Löschungspulses wird erfindungsgemäß erneut kurz gepulst, was gemäß dem einschlägigen Stand der Technik periodisch geschieht und entsprechende Nachteile hinsichtlich der Bearbeitungsrate bedingt. Erfindungsgemäß ist die Zeitspanne nach Beendigung eines Pulses bis zum Auslösen des nächsten Pulses dagegen nicht fest vorgegeben, sondern wird in Abhängigkeit von zeitlichen Verläufen für Ausgangsstrom und Ausgangsspannung an der Gleichspannungsquelle 3 (Fig. 1) sowie aus den Zeitpunkten zumindest eines vorangehenden Bogenentladungs-Löschungspulses bestimmt. Dabei wird eine entsprechende Berechnung des Puls-Einsatzzeitpunktes durch die Recheneinheit 9 der Steuereinheit 6 gemäß Fig. 1 nach jedem Puls erneut durchgeführt.

Fig. 4 zeigt ein Zeitablaufdiagramm zur Darstellung einer weiteren Ausgestaltung des erfindungsgemäßen Verfahrens. In Fig. 4 ist bei P(-1), bei P(0) und bei P(x) jeweils ein Bogenentladungs-Löschungspuls schematisch dargestellt. Dabei bezeichnet P(-1) einen vorangehenden Puls, P(0) einen gegenwärtigen Puls und P(x) einen zukünftigen (erneuten) nachfolgenden Puls. Die Markierungen t(-1), t(0) und t(x) auf der Zeitachse t bezeichnen den jeweiligen Anfangs- oder Einsatzzeitpunkt der Pulse P(-1), P(0) bzw. P(x), d.h. der dadurch bewirkten Gegenmaßnahmen. Zwischen der Beendigung des Pulses P(-1) und dem Einsatzzeitpunkt t(0) des Pulses P(0) liegt eine Zeit T3, während zwischen der Beendigung des Pulses P(0) und dem Einsatzzeitpunkt t(x) des Pulses P(x) eine zweite Zeit T2 liegt.

Erfindungsgemäß wird nun nach Ablauf der zweiten Zeit T2 seit Beendigung des Pulses P(0) ein erneuter Puls, d.h. der Puls P(x) ausgelöst, wobei die Zeit T2 für jeden erneuten Puls P(x) bezogen auf einen jeweiligen gegenwärtigen Puls P(0) neu berechnet wird. Dabei basiert die Berechnung der zweiten Zeit T2 insbesondere auf dem zeitlichen Abstand des gegenwärtigen Pulses P(0) zu dem vorangehenden Puls P(-1), d.h. auf dem Wert für die Zeit T3.

Beispielsweise kann der Zeitpunkt t(x) für das Auslösen des nächsten Pulses P(x) mittels der folgenden Beziehung bestimmt werden:

$$t(x) = [t(0) - t(-1)] \cdot k.$$

Hierbei bezeichnet t(x) den Einsatzzeitpunkt des nächsten Pulses P(x), d.h. der nächsten Austastung, t(-1) bezeichnet den Einsatzzeitpunkt des vorangegangenen Pulses P(-1), t(0) bezeichnet den Einsatzzeitpunkt des aktuellen Pulses P(0) und k bezeichnet einen Koeffizienten oder numerischen Faktor, der die erfindungsgemäße Verlängerung oder Verkürzung der Zeitspanne T2 gegenüber der Zeitspanne T3 steuert. Wenn der vorangegangene Puls P(-1) von einer tatsächlich erkannten Bogenentladung verursacht wurde, wird für k ein Faktor k1 gewählt, der typischerweise kleiner 1 ist, k1 < 1. Der Faktor k1 liegt dabei typischerweise im Bereich zwischen 0,5 und 1. Auf diese Weise rückt der nächste Puls P(x) näher an den gegenwärtigen Puls P(0) heran, d.h. T2 < T3. Wenn der vorgehende Puls P(-1) von einer vorhergesagten Bogenentladung ausgelöst wurde, d.h. nicht weil tatsächlich eine solche anhand der elektrischen Kenngröße erkannt, sondern weil eine solche nach dem erfindungsgemäßen Verfahren antizipiert wurde, wird ein Faktor k2 gewählt, der typischerweise größer 1 ist, k2 > 1. Auf diese Weise wächst der zeitliche Abstand zwischen den Pulsen P(x) und P(0), d.h. T2 > T3.

Nachfolgend sollen die vorstehenden Ausführungen anhand eines einfachen Zahlenbeispiels verdeutlicht werden. Angenommen, der gegenwärtige Zeitpunkt sei t = 0 μs. Dann gilt für t(-1) = -25 μs, t(0) = -1 μs und k = k1 = 0,5, dass t(x) = (-1 μs - (-25 μs)) · 0,5 = 12 μs. Somit wird nach t(x) - t = 12 μs ein erneuter Puls P(x) ausgelöst, wobei der Pulsabstand abnimmt.

Erfindungsgemäß können dabei Grenzwerte für den Zeitpunkt t(x) bzw. die Pulshäufigkeit in einem bestimmten Zeitintervall festgelegt werden. Beispielsweise kann zum Schutz von Leistungsschaltern in der erfindungsgemäßen Gleichspannungsversorgungseinrichtung 1 (Fig. 1) ein zeitlicher Grenzwert definiert werden, der dafür sorgt, dass die Pulse nicht häufiger auftreten, als die Belastbarkeit der Leistungsschalter zulässt. Ein weiterer, unterer Grenzwert kann festgelegt werden, wenn ein bestimmter Plasmaprozess einen Mindestwert wiederholter Pulse erfordert. Beispielsweise kann zum Erreichen bestimmter Schichteigenschaften in Plasma-Abscheideprozessen ein periodisches Pulsen mit niedriger Frequenz vorteilhaft sein.

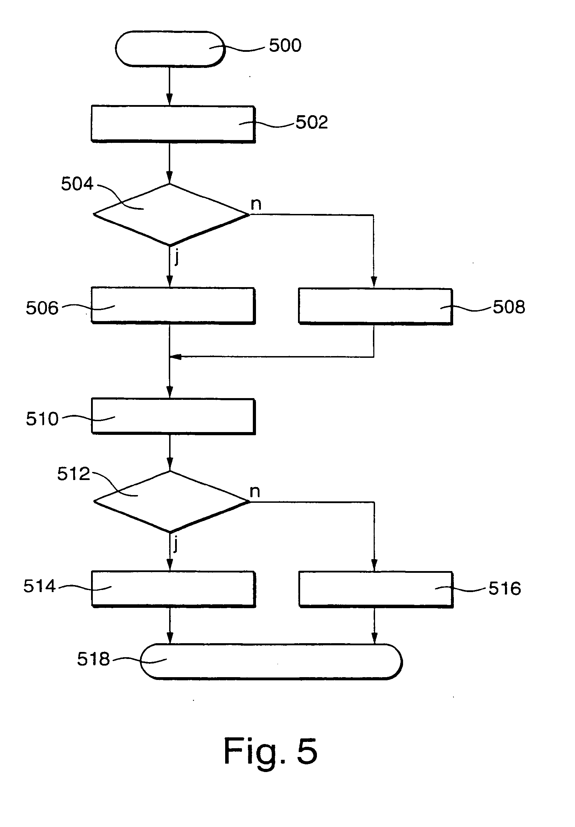

Die vorstehenden Ausführungen sind nachfolgend in Fig. 5 nochmals zusammenfassend dargestellt.

Fig. 5 zeigt ein Flussdiagramm zur Darstellung einer weiteren Ausgestaltung des erfindungsgemäßen Verfahrens. Das erfindungsgemäße Verfahren gemäß Fig. 5 beginnt mit Schritt 500 und läuft größtenteils in der Recheneinheit 9 der Steuereinheit 6 gemäß Fig. 1 ab.

Zunächst wird in Schritt 502 der Einsatzzeitpunkt t(-1) eines vorhergehenden Pulses ermittelt, beispielsweise durch Auslesen entsprechender Werte aus der Speichereinheit 8 der Steuereinheit 6. Anschließend wird in Schritt 504 überprüft, ob es sich bei dem entsprechenden Puls P(-1) um einen durch eine Bogenentladung ausgelösten oder einen vorhergesagten Puls gehandelt hat. Auch dies kann erfindungsgemäß durch Überprüfen von entsprechenden Informationen erfolgen, die in der Speichereinheit 8 abgelegt sind. Falls der Puls P(-1) durch eine tatsächlich erkannte Bogenentladung ausgelöst wurde (j), also beispielsweise mit einem entsprechenden Signalzustand des Überwachungssignals MS (z.B. MS = 1) verknüpft ist, wird zugleich mit der nächsten Einsatzzeit in Schritt 506 der Faktor k = k1 ausgewählt. Andernfalls wird in Schritt 508 der Faktor k = k2 ausgewählt. In jedem Fall erfolgt anschließend in Schritt 510 die Berechnung des Einsatzzeitpunktes t(x) des nächsten Pulses P(x) gemäß der angegebenen Formel, wobei für den Faktor k der entsprechende Wert gemäß Schritt 506 oder 508 eingesetzt wird. Anschließend wird in Schritt 512 gegebenenfalls bis zum Erreichen der berechneten t(x) überprüft, ob in dem betriebenen Plasmaprozess eine Bogenentladung erkannt wird, wie oben detailliert beschrieben. Ist dies der Fall (j), so wird in Schritt 514 vorgegangen, wie oben unter Bezugnahme auf Fig. 3 beschrieben. Anderenfalls (n) wird der nächste Puls P(x) mit dem berechneten Einsatzzeitpunkt t(x) in Schritt 516 erzeugt. Das Verfahren endet in jedem Fall mit Schritt 518.

Obwohl die Beschreibung der Vorteile und Ausführungsformen der vorliegenden Erfindung sich auf Anwendungen in Gleichspannungsversorgungen für Plasmaprozesse konzentriert, sei darauf hingewiesen, dass die vorliegende Erfindung in gleicher Weise auf bipolar gepulste, Mittelfrequenz- und Hochfrequenz (HF)-Plasmastromversorgungen anwendbar ist.

**Patentansprüche**

1. Verfahren zum Unterdrücken von Bogenentladungen beim Betreiben eines Plasmaprozesses (2), bei dem als Gegenmaßnahme zur Unterdrückung von Bogenentladungen eine Leistungsversorgung des Plasmaprozesses in Abhängigkeit von wenigstens einer Kenngröße (KG) unterbrochen oder umgepolt wird, **dadurch gekennzeichnet, dass** ein zeitlicher Verlauf der Gegenmaßnahme selektiv in Abhängigkeit von wenigstens einem der nachfolgenden Parameter bestimmt wird:

   - zeitlicher Abstand (T3) zu wenigstens einer vorhergehenden Gegenmaßnahme;
   - Verlauf der wenigstens einen Kenngröße (KG) seit einem betreffenden Einsatzzeitpunkt oder seit einer variablen Zeit vor dem betreffenden Einsatzzeitpunkt;
   - Unterscheidung, ob eine vorhergehende Gegenmaßnahme aufgrund des Verlaufs der wenigstens einen Kenngröße oder aufgrund des zeitlichen Abstands zu wenigstens einer vorhergehenden Gegenmaßnahme ausgelöst wurde.

2. Verfahren nach Anspruch 1, weiter **dadurch gekennzeichnet, dass** ein Einsatzzeitpunkt (t(x)) der Gegenmaßnahme selektiv in Abhängigkeit von wenigstens einem der nachfolgenden Parameter bestimmt wird:

   - zeitlicher Abstand (T3) zu wenigstens einer vorhergehenden Gegenmaßnahme;
   - Verlauf der wenigstens einen Kenngröße (KG) seit einem betreffenden Einsatzzeitpunkt oder seit einer variablen Zeit vor dem betreffenden Einsatzzeitpunkt;

- Unterscheidung, ob eine vorhergehende Gegenmaßnahme aufgrund des Verlaufs der wenigstens einen Kenngröße oder aufgrund des zeitlichen Abstands zu wenigstens einer vorhergehenden Gegenmaßnahme ausgelöst wurde.

3. Verfahren nach Anspruch 1 oder 2, weiter **dadurch gekennzeichnet, dass** die Gegenmaßnahme unmittelbar, d.h. innerhalb einiger 100 Nanosekunden nach Erkennen einer Bogenentladung ausgelöst wird.

4. Verfahren nach Anspruch 3, weiter **dadurch gekennzeichnet, dass** Gegenmaßnahme während eines ersten Zeitintervalls (t1) durchgeführt wird, dessen zeitliche Dauer 1 bis 5 μs beträgt.

5. Verfahren nach einem der Ansprüche 1 bis 4, weiter **dadurch gekennzeichnet, dass** eine zeitliche Dauer (t1) einer ausgelösten Gegenmaßnahme in Abhängigkeit von dem Verlauf der Kenngröße (KG) durch Aktivierung eines zweiten Zeitintervalls (t2) verlängert wird, wenn der Verlauf der elektrischen Kenngröße (KG) eine nicht selbst verlöschende Bogenentladung anzeigt.

6. Verfahren nach Anspruch 5, weiter **dadurch gekennzeichnet, dass** das zweite Zeitintervall (t2) um ein Verlängerungsintervall (Δt2+) verlängert wird, wenn innerhalb einer ersten vorgegebenen Zeit (T1) nach Beendigung einer Gegenmaßnahme erneut eine Bogenentladung erkannt wird.

7. Verfahren nach Anspruch 5 oder 6, weiter **dadurch gekennzeichnet, dass** das zweite Zeitintervall (t2) um ein Verringerungsintervall (Δt2-) verkürzt wird, wenn innerhalb der ersten vorgegebenen Zeit (T1) keine erneute Bogenentladung erkannt wird.

8. Verfahren nach Anspruch 7, weiter **dadurch gekennzeichnet, dass** das zweite Zeitintervall (t2) schrittweise bis auf einen vorgegebenen Minimalwert (t2min) verkürzt wird.

9. Verfahren nach einem der Ansprüche 1 bis 8, weiter **dadurch gekennzeichnet, dass** nach Ablauf einer zweiten Zeit (T2) seit Beendigung einer Gegenmaßnahme eine erneute Gegenmaßnahme durchgeführt wird, wobei die zweite Zeit für jede erneute Gegenmaßnahme neu bestimmt wird.

10. Verfahren nach Anspruch 9, weiter **dadurch gekennzeichnet, dass** die zweite Zeit (T2) basierend auf dem Verlauf der elektrischen Kenngröße (KG) und/oder dem zeitlichen Abstand (T3) zu wenigstens einer vorhergehenden Gegenmaßnahme bestimmt wird.

11. Verfahren nach Anspruch 9 oder 10, weiter **dadurch gekennzeichnet, dass** das Bestimmen der zweiten Zeit (T2) gemäß der folgenden Beziehung erfolgt:

$$t(x) = [t(0) - t(-1)] \cdot k,$$

wobei t(x) einen Einsatzzeitpunkt der erneuten Gegenmaßnahme, t(0) einen Einsatzzeitpunkt einer aktuellen Gegenmaßnahme, t(-1) einen Einsatzzeitpunkt der vorhergehenden Gegenmaßnahme und k einen numerischen Faktor bezeichnet.

12. Verfahren nach Anspruch 11, weiter **dadurch gekennzeichnet, dass** k = k1, 0,5 ≤ k1 ≤ 1, gewählt wird, falls die vorhergehende Gegenmaßnahme aufgrund Erkennen einer Bogenentladung ausgelöst wurde, und dass k = k2, k2 > 1, gewählt wird, falls die vorhergehende Gegenmaßnahme unabhängig von einem Erkennen einer Bogenentladung nach Ablauf einer zweiten Zeit (T2) ausgelöst wurde.

13. Verfahren nach einem der Ansprüche 1 bis 12, weiter **dadurch gekennzeichnet, dass** für eine zeitliche Abfolge der Gegenmaßnahmen ein unterer und/oder ein oberer Grenzwert vorgegeben wird.

14. Bogenentladungserkennungseinrichtung (4) für einen Plasmaprozess (2), aufweisend:

- eine Überwachungseinheit (5), die zum Überwachen wenigstens einer Kenngröße (KG) zum Erkennen einer Bogenentladung in dem Plasmaprozess anhand der Kenngröße und zum Ausgeben eines entsprechenden Überwachungssignals (MS) ausgebildet ist;
- eine Steuereinheit (6), die zum Empfangen des Überwachungssignals von der Überwachungseinheit (5) und zum Ausgeben eines Steuersignals (SS) zum Bewirken einer Gegenmaßnahme zum Unterdrücken der Bogenentladung ausgebildet ist;
- eine Timer-Einheit (7), die zum Liefern eines Zeitreferenzsignals (TS) an die Steuereinheit (6) ausgebildet ist;

**dadurch gekennzeichnet, dass** die Steuereinheit (6) dafür eingerichtet ist, ein Verfahren nach einem der vorangehenden Ansprüche durchzuführen.

15. Plasmaleistungsversorgungseinrichtung (1) mit einer Leistungsquelle (3) für eine Lesitungsversorgung des Plasmaprozesses, **gekennzeichnet durch** eine Bogenentladungserkennungseinrichtung (4) nach Anspruch 14 in Wirkverbindung mit der Leistungsquelle (3).

## Claims

1. A method for the suppression of arc discharges in the operation of a plasma process (2), in which as a countermeasure for the suppression of arc discharges a power supply to the plasma process is interrupted or reversed in polarity as a function of at least one parameter (KG), **characterised in that** a timewise behaviour of the countermeasure is selectively determined as a function of at least one of the following parameters:

   - an interval in time (T3) from at least one previous countermeasure;
   - a behaviour of the at least one parameter (KG) since a relevant time of introduction, or since a variable period of time ahead of the relevant time of introduction;
   - a differentiation as to whether a previous countermeasure was triggered due to the behaviour of the at least one parameter, or due to the interval in time from at least one previous countermeasure.

2. The method according to Claim 1, further **characterised in that** a time of introduction (t(x)) of the countermeasure is selectively determined as a function of at least one of the following parameters:

   - an interval in time (T3) from at least one previous countermeasure;
   - a behaviour of the at least one parameter (KG) since a relevant time of introduction, or since a variable period of time prior to the relevant time of introduction;
   - a differentiation as to whether a previous countermeasure has been triggered on the basis of the behaviour of the at least one parameter, or on the basis of the interval in time from at least one previous countermeasure.

3. The method according to Claim 1 or 2, further **characterised in that** the countermeasure is triggered immediately, i.e. within a few 100 nanoseconds after detection of an arc discharge.

4. The method according to Claim 3, further **characterised in that** the countermeasure is executed during a first time interval (t1), the time of duration of which is 1 to 5 $\mu$s.

5. The method according to one of the Claims 1 to 4, further **characterised in that** a time of duration (t1) of a triggered countermeasure is extended as a function of the behaviour of parameter (KG) by the activation of a second time interval (t2), if the behaviour of the electrical parameter (KG) indicates a non self-extinguishing arc discharge.

6. The method according to Claim 5, further **characterised in that** the second time interval (t2) is extended by an extension interval ($\Delta$t2+), if within a first prescribed period of time (T1) after termination of a countermeasure a new arc discharge is detected.

7. The method according to Claim 5 or 6, further **characterised in that** the second time interval (t2) is shortened by a reduction interval ($\Delta$t2-), if within the first prescribed period of time (T1) no new arc discharge is detected.

8. The method according to Claim 7, further **characterised in that** the second time interval (t2) is shortened in a stepwise manner down to a given minimum value (t2min).

9. The method according to one of the Claims 1 to 8, further **characterised in that** after elapse of a second period of time (T2) since termination of a countermeasure a new countermeasure is executed, wherein the second period of time is newly determined for each new countermeasure.

10. The method according to Claim 9, further **characterised in that** the second period of time (T2) is determined based on the behaviour of the electrical parameter (KG) and/or the interval in time (T3) from at least one previous countermeasure.

11. The method according to Claim 9 or 10, further **characterised in that** the determination of the second period of time (T2) takes place according to the following equation:

$$t(x) = [t(0) - t(-1)] \cdot k,$$

wherein t(x) denotes a time of introduction of the renewed countermeasure, t(0) denotes a time of introduction of a current countermeasure, t(-1) denotes a time of introduction of the previous countermeasure, and k denotes a numerical factor.

12. The method according to Claim 11, further **characterised in that** k = k1, $0.5 \leq k1 \leq 1$, is selected if the previous countermeasure has been triggered on the basis of detection of an arc discharge, and **in that** k = k2, k2 > 1, is selected if the previous countermeasure has been triggered independently of any detection of an arc discharge after elapse of a second period of time (T2).

**13.** The method according to one of the Claims 1 to 12, further **characterised in that** for a timewise sequence of the countermeasures a lower and/or an upper limiting value is prescribed.

**14.** An arc discharge detection device (4) for a plasma process (2), having:

- a monitoring unit (5), which is designed to monitor at least one parameter (KG) for the detection of an arc discharge in the plasma process with the aid of the parameter, and to output a corresponding monitoring signal (MS);
- a control unit (6), which is designed to receive the monitoring signal from the monitoring unit (5) and to output a control signal (SS) to effect a countermeasure for the suppression of the arc discharge;
- a timer unit (7), which is designed to supply a time reference signal (TS) to the control unit (6);

**characterised in that** the control unit (6) is adapted to execute a method according to one of the previous claims.

**15.** A plasma power supply device (1) with a power source (3) for a power supply to the plasma process, **characterised by** an arc discharge detection device (4) according to Claim 14 in a functional connection with the power source (3).

**Revendications**

**1.** Procédé pour supprimer les décharges en arc lors de l'exploitation d'un procédé plasma (2), dans lequel, en tant que contre-mesure pour supprimer les décharges en arc, une alimentation en énergie du procédé plasma est interrompue ou inversée en fonction d'au moins une grandeur caractéristique (KG), **caractérisé en ce qu'**une variation dans le temps de la contre-mesure est déterminée sélectivement en fonction d'au moins un des paramètres suivants :

- distance temporelle (T3) par rapport à au moins une contre-mesure précédente ;
- variation de ladite au moins une grandeur caractéristique (KG) depuis un instant d'entrée en action concerné ou depuis un temps variable avant l'instant d'entrée en action concerné ;
- discrimination pour déterminer si une contre-mesure précédente a été déclenchée en raison de la variation de ladite au moins une grandeur caractéristique ou en raison de la distance temporelle par rapport à au moins une contre-mesure précédente.

**2.** Procédé selon la revendication 1, **caractérisé en outre en ce qu'**un instant d'entrée en action (t(x)) de la contre-mesure est déterminé sélectivement en fonction d'au moins un des paramètres suivants :

- distance temporelle (T3) par rapport à au moins une contre-mesure précédente ;
- variation de ladite au moins une grandeur caractéristique (KG) depuis un instant d'entrée en action concerné ou depuis un temps variable avant l'instant d'entrée en action concerné ;
- discrimination pour déterminer si une contre-mesure précédente a été déclenchée en raison de la variation de ladite au moins une grandeur caractéristique ou en raison de la distance temporelle par rapport à au moins une contre-mesure précédente.

**3.** Procédé selon la revendication 1 ou 2, **caractérisé en outre en ce que** la contre-mesure est déclenchée immédiatement, c'est-à-dire dans un délai de quelques 100 nanosecondes après détection d'une décharge en arc.

**4.** Procédé selon la revendication 3, **caractérisé en outre en ce que** la contre-mesure est appliquée pendant un premier intervalle de temps (t1) dont la durée temporelle est à 1 à 5 $\mu$s.

**5.** Procédé selon une des revendications 1 à 4, **caractérisé en outre en ce qu'**une durée temporelle (t1) d'une contre-mesure déclenchée en fonction de la variation de la grandeur caractéristique (KG) est prolongée par activation d'un deuxième intervalle de temps (t2) si la variation de la grandeur caractéristique électrique (KG) indique une décharge en arc non auto-extinguible.

**6.** Procédé selon la revendication 5, **caractérisé en outre en ce que** le deuxième intervalle de temps (t2) est prolongé d'un intervalle de prolongation ($\Delta$t2+) si une décharge en arc est de nouveau détectée pendant un premier temps prédéfini (T1) après la fin d'une contre-mesure.

**7.** Procédé selon la revendication 5 ou 6, **caractérisé en outre en ce que** le deuxième intervalle de temps (t2) est raccourci d'un intervalle de diminution ($\Delta$t2-) si aucune nouvelle décharge en arc n'est détectée pendant le premier temps prédéfini (T1).

**8.** Procédé selon la revendication 7, **caractérisé en outre en ce que** le deuxième intervalle de temps (t2) est raccourci pas à pas jusqu'à une valeur minimale prédéfinie (t2min).

**9.** Procédé selon une des revendications 1 à 8, **caractérisé en outre en ce qu'**une nouvelle contre-mesure est appliquée après expiration d'un deuxième temps (T2) depuis la fin d'une contre-mesure, le deuxième temps étant déterminé à nouveau pour chaque nouvelle contre-mesure.

10. Procédé selon la revendication 9, **caractérisé en outre en ce que** le deuxième temps (T2) est déterminé sur la base de la variation de la grandeur caractéristique électrique (KG) et/ou de la distance temporelle (T3) par rapport à au moins une contre-mesure précédente.

11. Procédé selon la revendication 9 ou 10, **caractérisé en outre en ce que** le deuxième temps (T2) est déterminé selon la relation suivante :

$$t(x) = [t(0) - t(-1)] \cdot k,$$

dans laquelle t(x) désigne un instant d'entrée en action de la nouvelle contre-mesure, t(0) un instant d'entrée en action d'une contre-mesure actuelle, t(-1) un instant d'entrée en action de la contre-mesure précédente et k un facteur numérique.

12. Procédé selon la revendication 11, **caractérisé en outre en ce que** l'on choisit k = k1, $0,5 \le k1 \le 1$, si la contre-mesure précédente a été déclenchée en raison de la détection d'une décharge en arc, et que l'on choisit k = k2, k2 > 1, si la contre-mesure précédente a été déclenchée indépendamment d'une détection d'une décharge en arc à l'expiration d'un deuxième temps (T2).

13. Procédé selon une des revendications 1 à 12, **caractérisé en outre en ce qu'**une valeur limite inférieure et/ou supérieure est prédéfinie pour une succession temporelle des contre-mesures.

14. Dispositif de détection de décharges en arc (4) pour un procédé plasma (2), présentant :

- une unité de surveillance (5) qui est conçue pour surveiller au moins une grandeur caractéristique (KG) pour détecter une décharge en arc dans le procédé plasma à l'aide de la grandeur caractéristique et pour délivrer un signal de surveillance (MS) correspondant ;
- une unité de commande (6) qui est conçue pour recevoir le signal de surveillance de l'unité de surveillance (5) et pour délivrer un signal de commande (SS) pour déclencher une contre-mesure dans le but de supprimer la décharge en arc ;
- une unité de temporisation (7) qui est conçue pour fournir un signal de référence de temps (TS) à l'unité de commande (6) ;

**caractérisé en ce que** l'unité de commande (6) est conçue pour réaliser un procédé selon une des revendications précédentes.

15. Dispositif d'alimentation en énergie plasma (1) avec une source d'énergie (3) pour une alimentation en énergie du procédé plasma, **caractérisé par** un dispositif de détection de décharges en arc (4) selon la revendication 14 en liaison fonctionnelle avec la source d'énergie (3).

Fig. 1

Fig. 2

Fig. 4

Fig. 3

Fig. 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0692138 B1

- EP 1705687 A1